# EUROPEAN PATENT SPECIFICATION

(11) **EP 0 978 880 B1**
(45) Date of publication and mention of the grant of the patent: **06.10.2010**
(21) Application number: 98306353.8
(22) Date of filing: 07.08.1998
(51) Int. Cl.: H01L 27/32

(54) **Organic electroluminescent display panel and method for fabricating the same**
Organische Elektrolumineszenzanzeige und Verfahren zu deren Herstellung
Panneau d'affichage électroluminescent en matière organique et procédé pour sa fabrication

(43) Date of publication of application: 09.02.2000
(60) Divisional application: 10005091.3
(73) Proprietor: LG Electronics, Inc., Seoul (KR)
(72) Inventor: Kim, Sung Tae, Eunpyung-gu, Seoul (KR); Yoon, Jong Guen, Youngdungpo-ku, Seoul (KR); Kim, Chang Nam, Chungnang-gu, Seoul (KR)
(74) Representative: McLeish, Nicholas Alistair Maxwell

(56) References cited:
- EP-A- 0 717 446
- EP-A2- 0 767 599
- WO-A-97/38445
- JP-A- 9 102 392
- US-A- 5 701 055
- US-A- 5 790 216
- PATENT ABSTRACTS OF JAPAN vol. 016, no. 300 (E-1227), 2 July 1992 & JP 04 082197 A (HITACHI LTD), 16 March 1992

## Description

### BACKGROUND OF THE INVENTION

### Field of the Invention

The present invention relates to an organic electroluminescent (hereinafter referred to as EL) display panel comprising organic EL elements which emit light when electric charges are injected to an emitting layer.

### Discussion of the Related Art

The technology of organic EL devices, also called organic light emitting diodes (LEDs), has been rapidly advancing, and several prototype modules have been successfully demonstrated at exhibitions. Organic EL devices are extremely thin, matrix-addressable and operable at a relatively low voltage, typically less than 15 volts. Furthermore, they have additional features suitable for next generation flat panel displays (FPDs) such as, among other things, little dependence on viewing angle and good device-formability on flexible substrates. A major drawback of liquid crystal display, currently most well-known display of choice, is that most of them require bright backlighting, which can be easily eliminated by the use of an organic EL display.

Organic LEDs differ fundamentally from conventional inorganic LEDs. While the charge transfer in inorganics is band-like in nature and the electron-hole recombination results in the interband emission of light, organic films are generally characterized by the low-mobility activated hopping transport and the emission is excitonic. Organic EL devices are also substantially different from conventional inorganic EL devices, especially in that organic EL devices are operable at low DC voltages.

A substantial amount of research has been directed towards the efficiency improvement and color control of organic LEDs. The efficiency of organic EL devices has now been demonstrated to be certainly adequate for many commercial applications. Moreover, color control is probably not limiting for most potential applications. In light of this, we believe that the outlook for commercial applications is excellent for organic EL devices. The performance of the organic EL devices is quite satisfactory for many applications. It is valuable to think in terms of specific products and manufacturing techniques for the commercialization of organic EL devices. Consideration of the specific applications leads us to believe that more work on manufacturability, uniformity, reliability, and systems issues is required to commercialize organic EL.

For the applications to large flat panel displays, it is critical to have uniform emission over the whole display screen, which may be obtained only when the organic function layer is formed uniformly over the whole active viewing area. There is another important issue indirectly but closely associated with the fabrication of a large organic EL display panel, i.e. difficulties which arise from driving a large organic EL panel with a passive matrix addressing scheme. The simplest way to drive an organic EL panel is to have organic function layers sandwiched between two sets of orthogonal electrodes, i.e. rows and columns. In this passive addressing scheme, the EL element serves both the display and switching functions. The diode-like nonlinear current-voltage characteristic of the organic EL element should, in principle, permit a high degree of multiplexing in this mode of addressing. However, the problems to be discussed below become apparent as an organic EL display panel becomes large.

First, it is well known that the RC time delay is significant in an organic EL display due to somewhat poor conductivity of indium tin oxide (ITO), a typical material for transparent electrode, and relatively large capacitance component of organic layers. As the panel size increases, the time delay becomes prohibitively large. More importantly, an organic EL display element does not have an intrinsic memory and so needs a very high peak luminance for a passive matrix addressing, which limits the number of rows of the display panel. The instantaneous peak luminance is proportional to (number of row) x (average luminance). To achieve an average display luminance of 100 cd/m², for example, the maximum number of rows will probably be limited to less than 500. The estimation is made with the assumption that a peak luminance is 50,000 cd/m², which is not trivial to achieve, and the device stability will certainly be a critical issue at that high luminance. In addition, the instantaneously high current causes large IR potential drops along the column and row buses, which should contribute to the non-uniformity of brightness over the panel surface.

A solution to the problems discussed above is to employ an active addressing scheme as in a thin film transistor liquid crystal display (TFT-LCD). But an active matrix EL (AM-EL) is costly to fabricate, and, more importantly, becomes less competitive compared to other display technologies, for example plasma display panel (PDP), as the display size becomes large. Thus, it is highly in demand to devise a practical way to fabricate a large passive addressable organic EL panel.

WO 97/38445, EP 0 767 599 and JP 09102392 each disclose an organic electroluminescent display panel as set out in the precharacterizing portion of claim 1. US 5790216 describes first and second bus electrodes for subpanels of a LC-display.

### SUMMARY OF THE INVENTION

Accordingly, the present invention is directed to an organic electroluminescent display panel that substantially addresses one or more of the problems due to limitations and disadvantages discussed in the above.

An object of the present invention is to provide a passive addressable organic electroluminescent display panel with a plurality of sub-panels and a method for manufacturing the same.

Additional features and advantages of the invention will be set forth in the description which follows and in part will be apparent from the description, or may be learned by practice of the invention. The objectives and other advantages of the invention will be realized and attained by the structure particularly pointed out in the written description and claims hereof as well as the appended drawings.

Accordingly, the invention provides an organic electroluminescent display panel as set out in claim 1, and a method of making an organic electroluminescent display panel as set out in claim 7.

Embodiments provide an organic electroluminescent display panel having a plurality of emitting portions comprising: a transparent substrate; a plurality of first electrodes formed on said transparent substrate, each first electrode made up of a plurality of stripes which are electrically isolated from each other, each stripe electrically connected to a first bus electrode made up of a single or a plurality of electrically conducting materials, each first bus electrode, if necessary, vertically stacked with an electrically insulating layer in between, each of said stacked layers made up of one or a plurality of first bus electrodes arranged side by side with an electrically insulating gap in between; organic function layers formed on said first electrodes, including at least one organic EL medium layer; and a plurality of second electrodes formed on said organic function layers, each second electrode made up of a plurality of stripes which are electrically isolated from each other, each stripe electrically connected to a second bus electrode made up of a single or a plurality of electrically conducting materials, each second bus electrode, if necessary, vertically stacked with an electrically insulating layer in between, each of said stacked layers made up of one or a plurality of second bus electrodes arranged side by side with an electrically insulating gap in between.

The organic EL display panel may further comprise a plurality of ramparts formed on corresponding second signal buses.

Preferably, a corresponding second electrode is formed on each rampart.

Preferably, a corresponding said at least one of first, second and third organic function layers is formed between the corresponding second electrode and each rampart.

The organic EL display panel may further comprise a rampart formed on a corresponding first signal bus located between adjacent sub-panels.

Preferably, each of said plurality of first and second electrodes comprises a plurality of first and second conductive layers, respectively, arranged in an array of columns and rows, each of said first and second conductive layers being isolated from each other.

Preferably, said plurality of first conductive layers is made of a light transmissive material.

Preferably, the light transmissive material is indium tin oxide.

Preferably, said substrate is light transmissive.

Preferably, said first conductive layers have a substantially rectangular shape.

Preferably, a corresponding first conductive layer in a corresponding sub-panel includes a plurality of notches on one side of the substantially rectangular shape.

Preferably, said plurality of second conductive layers is made of one of a low resistance metal and alloy.

Preferably, the low resistance metal is aluminium, and the alloy is one of Mg:Ag and Al:Li.

Preferably, said plurality of first signal buses is formed in a column direction between at least one of adjacent first conductive layers for coupling at a first side of a corresponding first conductive layer and corresponding first conductive layers for coupling at a second side, wherein the first and second sides are different sides of the first conductive layers.

Preferably, said plurality of second signal buses is formed in a row direction between at least one of adjacent second conductive layers for coupling at a first side of a corresponding second conductive layer and corresponding second conductive layer for coupling at a second side, wherein the first and second sides are different sides of the second conductive layers.

Preferably, each of said plurality of first signal buses comprises at least one conductive first connection formed on the substrate and a first insulating layer covering said conductive first connection and each of said plurality of second signal buses comprises a second insulation layer formed on the first conductive layer, at least one conductive second connection formed on the first conductive layer and a third insulation layer formed on the conductive second connection.

Preferably, each of said conductive first and second connections are made of at least one conductive material.

Preferably, the conductive material is at least one of a metal, an alloy and a conducting polymer.

Preferably, the metal is one of aluminum, copper, nickel, chromium, silver and gold.

Preferably, at least one of the conductive first connection is in contact with an entire first side of the corresponding first conductive layer and the conductive second connection is in contact with an entire first side of the corresponding second conductive layer.

Preferably, the first insulating layer isolates adjacent conductive first connections when there is more than one conductive first connection for each first signal bus and said third insulating layer isolates adjacent active second connections when there is more than one conductive connection for each second signal bus.

Preferably, at least one of the adjacent conductive first and second connections are vertically stacked.

### BRIEF DESCRIPTION OF THE DRAWINGS

The accompanying drawings, which are included to provide further understanding of the invention, and are incorporated in, and constitute a part of this specification, illustrate embodiments of the invention, and together with the description serve to explain the principles of the invention.

In the drawings:
Fig. 1 illustrates a plan view of an organic EL display panel in accordance with a preferred embodiment of the present invention;
Fig. 2 shows a plan view of a display panel having (4 x 4) sub-panels;
Fig. 3 is a schematic view illustrating the process of forming a plurality of first electrodes and a plurality of contact pads for first and second electrodes;
Fig. 4 is a schematic view illustrating the process of electrically connecting stripes of first electrodes and corresponding contact pads;
Fig. 5(a) is a close-up view of the four sub-panels designated as 2-f in Fig. 4, and Fig. 5(b) illustrates a cross-sectional view taken along the line A-A' in Fig. 5(a);

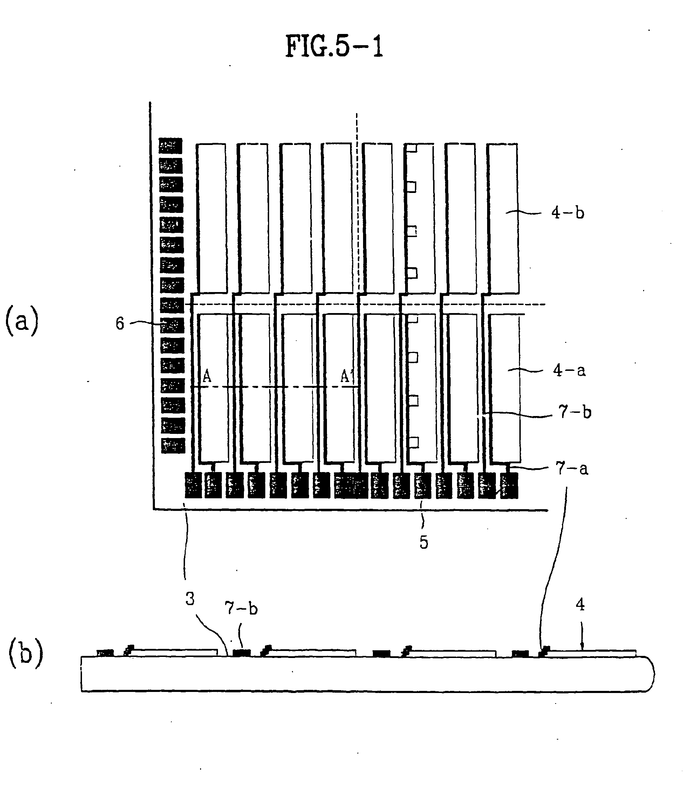

Fig. 5-1 depicts another way of electrically connecting stripes of first electrodes and corresponding contact pads;

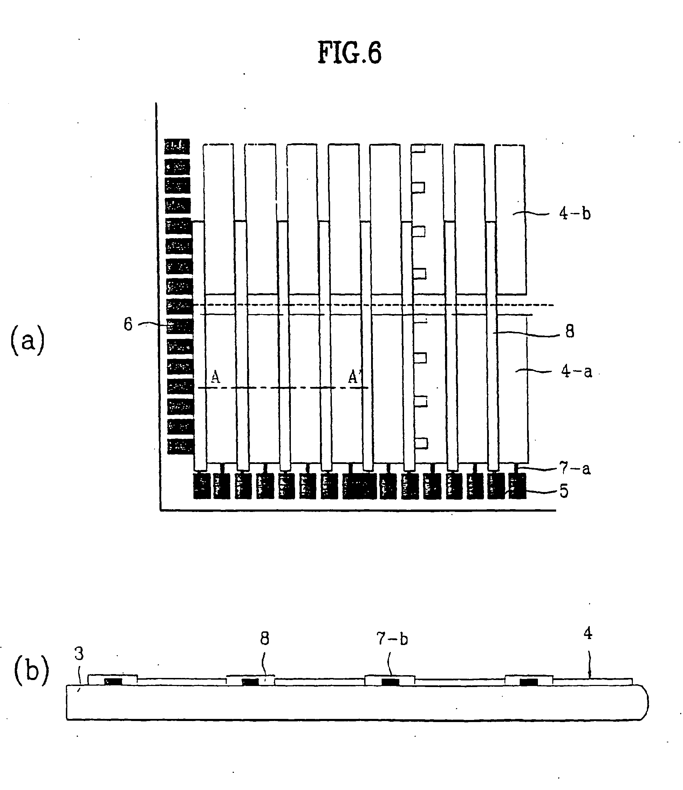

Fig. 6 is a plan view showing the process of covering first bus electrodes with an insulating layer;

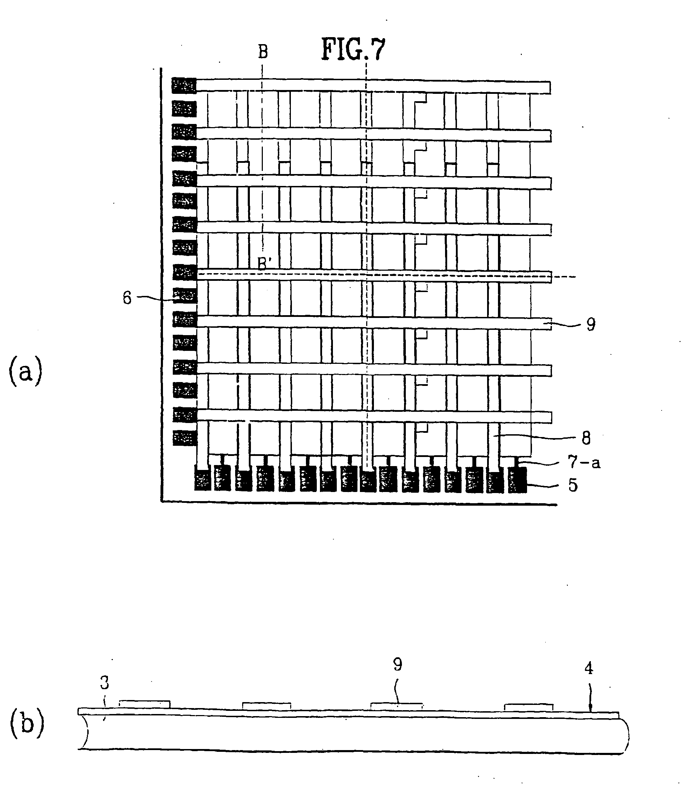

Fig. 7(a) is a schematic view illustrating the process of forming an insulating buffer layer for second bus electrodes, and Fig. 7(b) illustrates a cross-sectional view taken along the line B-B' in Fig. 7(a);

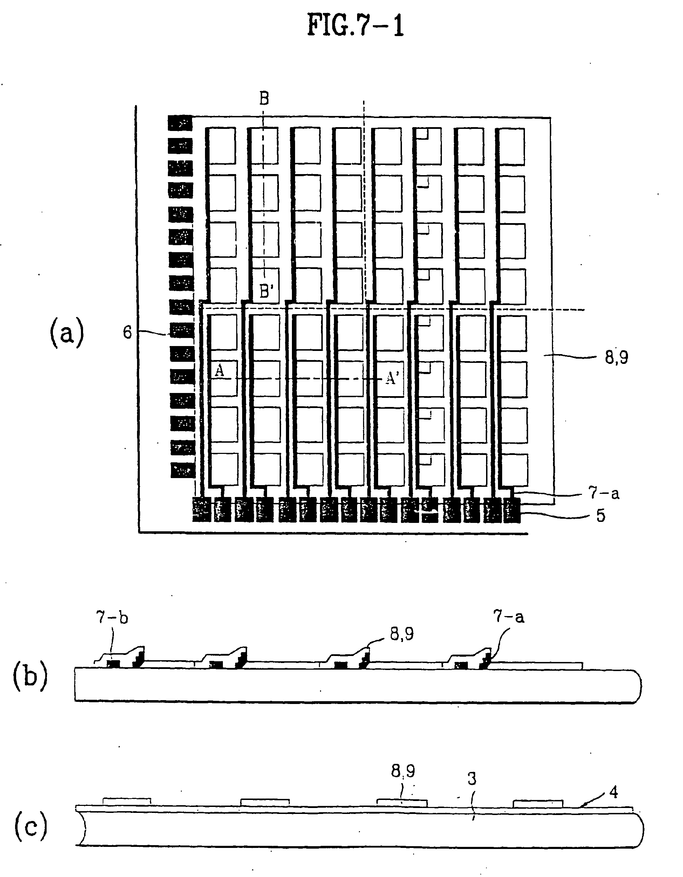

Fig. 7-1(a) illustrates a process wherein the two steps concerning Figs. 6 and 7 are performed together in a step; Figs. 7-1(b) and 7-1(c) show cross-sectional views taken along the lines A-A' and B-B', respectively;

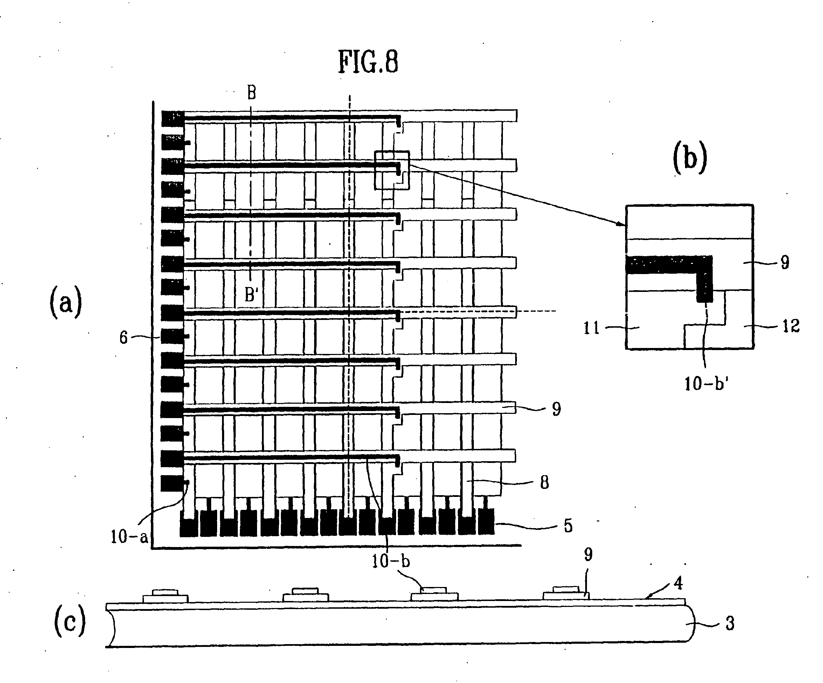

Fig. 8(a) is a plan view illustrating the process of forming second bus electrodes; Fig. 8(b) is an enlarged view, and Fig. 8(c) illustrates a cross-sectional view taken along the line B-B' in Fig. 8(a);

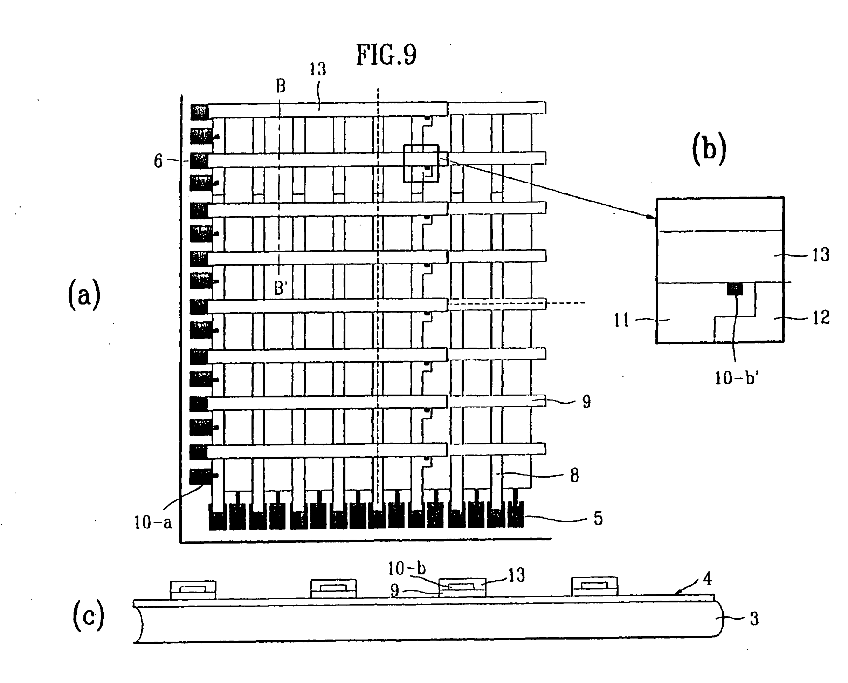

Fig. 9 is a plan view illustrating the process of forming an insulating layer for second bus electrodes;

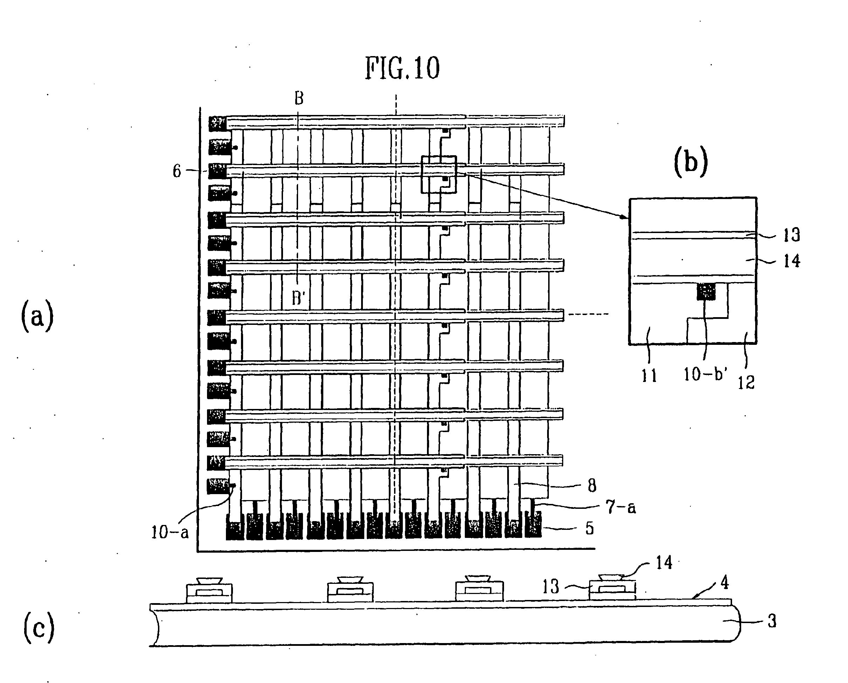

Fig. 10 illustrates the process of forming electrically insulating ramparts for pixelation;

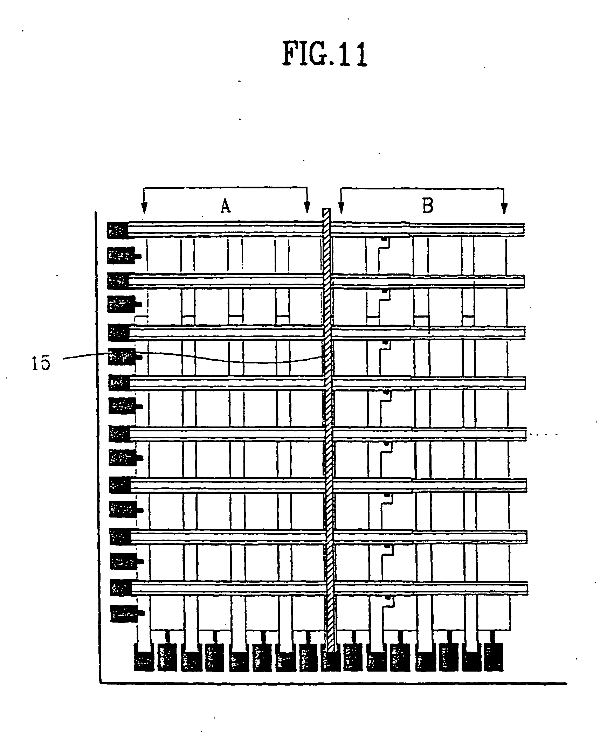

Fig. 11 exhibits the process of forming electrically insulating ramparts for electrically isolating second electrodes in A region from those in B region;

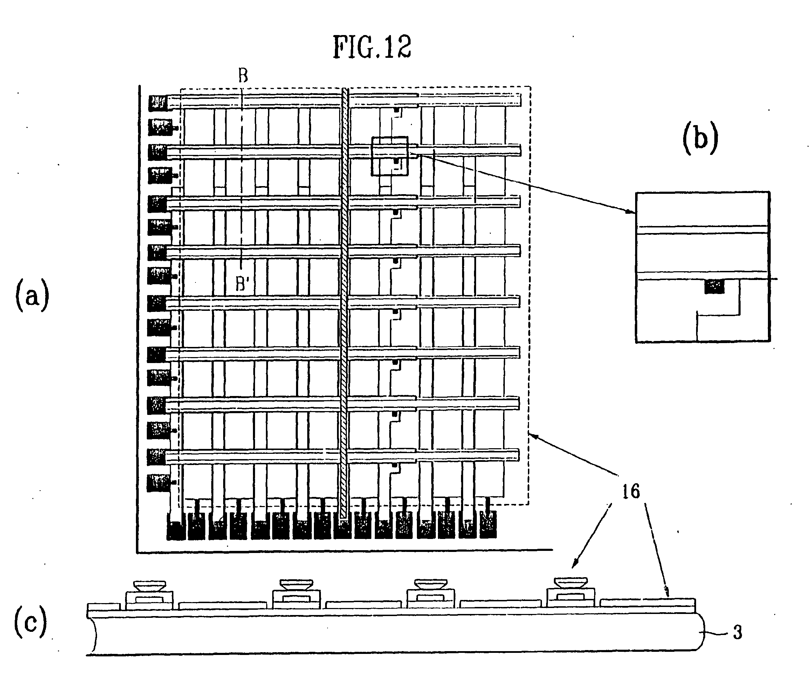

Fig. 12(a) illustrates the process of laminating organic function layers; Fig. 12(b) is a blow-up, and Fig. 12(c) shows a cross-sectional view taken along the line B-B' in Fig. 12(a);

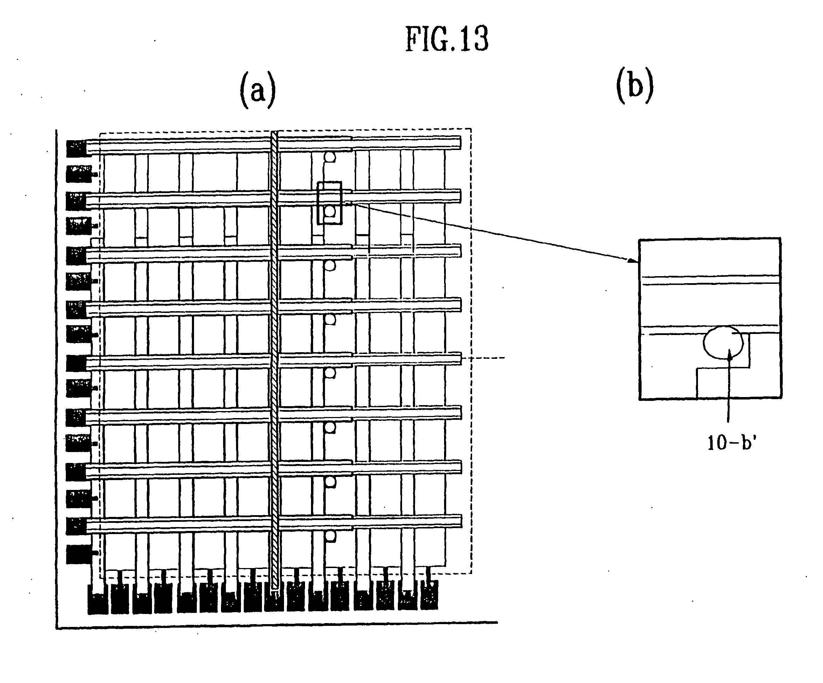

Fig. 13(a) illustrates the process of exposing a part of second bus electrode 10-b' by etching out organic function layers on top of said bus electrode 10-b'; Fig. 13(b) is a close-up;

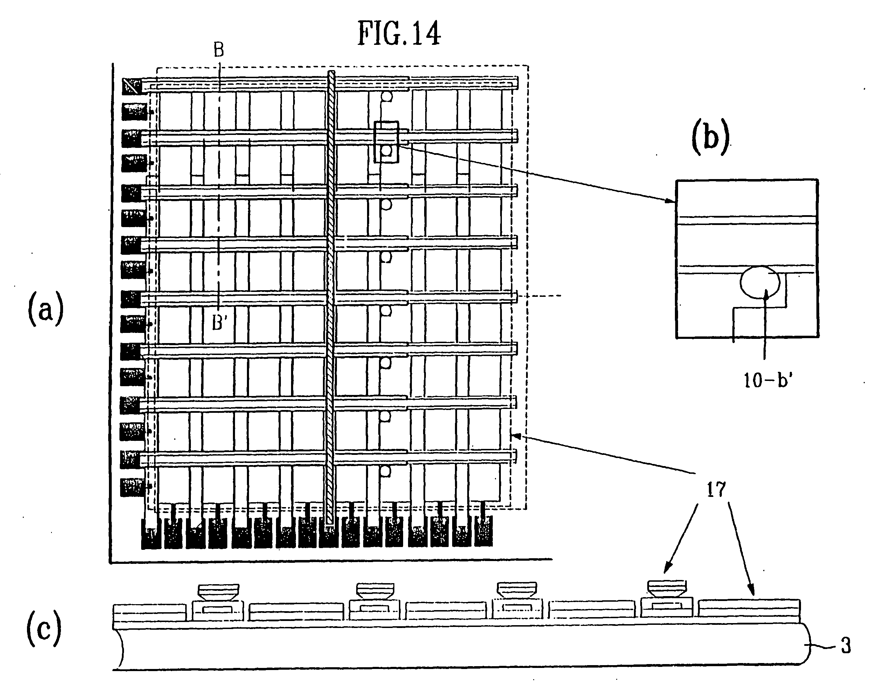

Fig. 14(a) illustrates the process of forming second electrodes; Fig. 14(b) is an enlarged view, and Fig. 14(c) shows a cross-sectional view taken along the line B-B' in Fig.14(a);

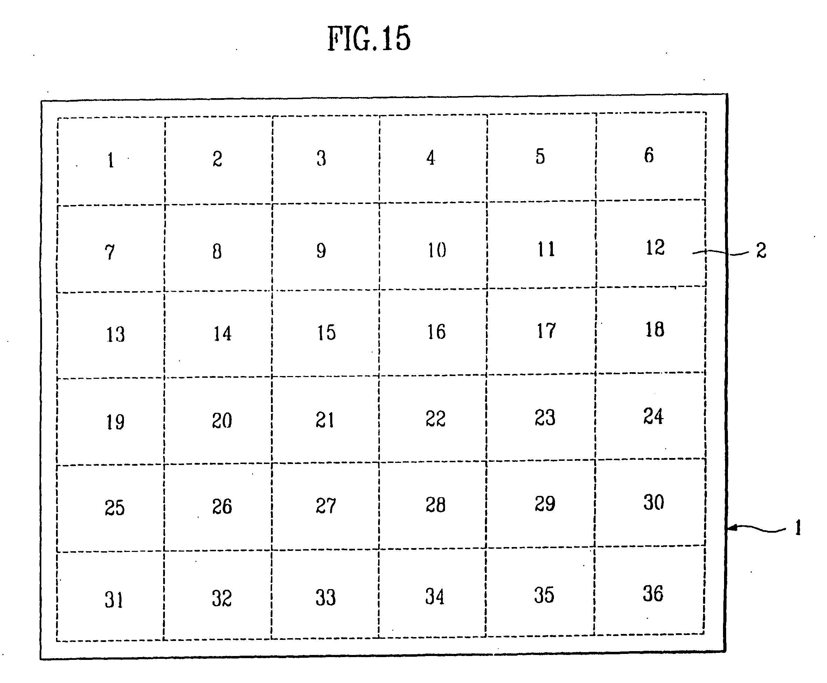

Fig. 15 shows a plan view of a display panel having (6 x 6) sub-panels;

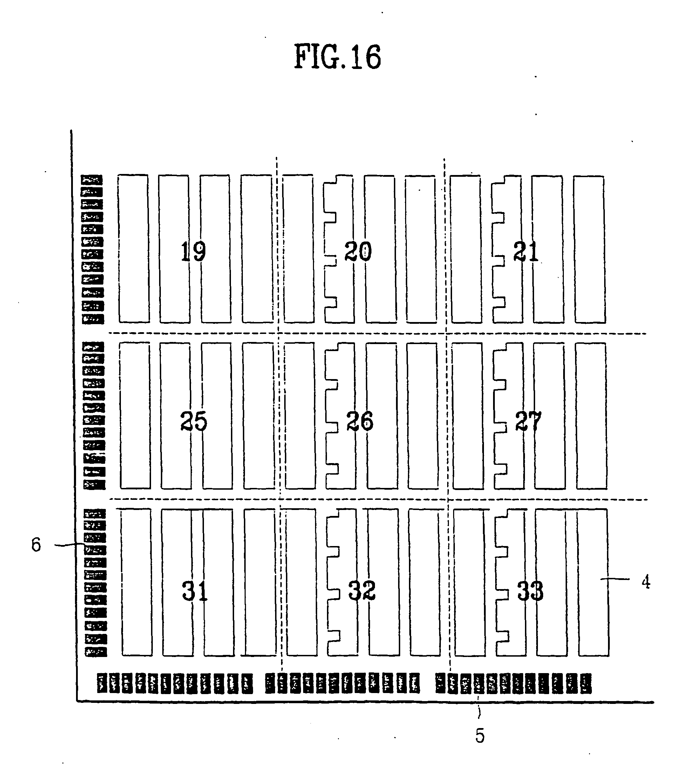

Fig. 16 is a close-up view illustrating the process of forming a plurality of first electrodes and a plurality of contact pads for first and second electrodes;

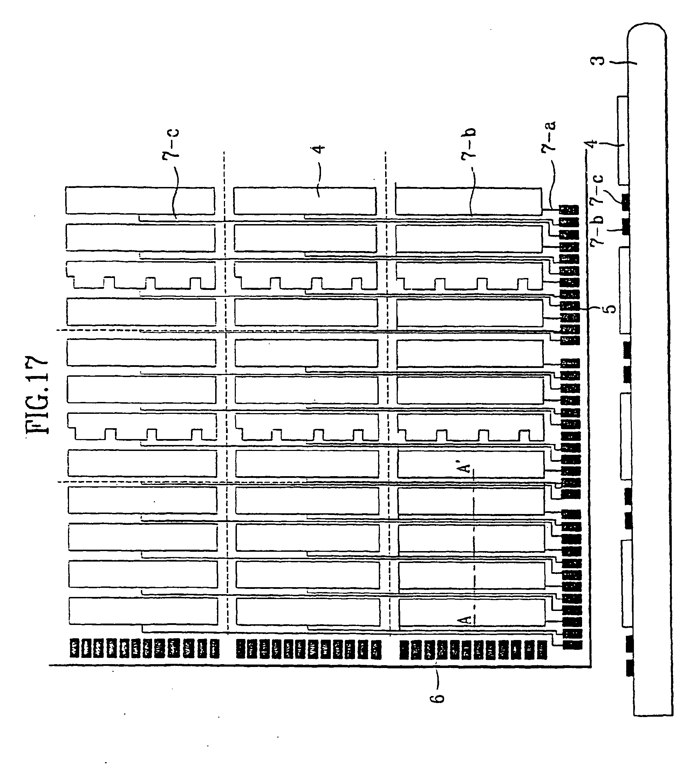

Fig. 17(a) is a schematic view illustrating the process of connecting stripes of first electrodes and corresponding contact pads, and Fig. 17(b) illustrates a cross-sectional view taken along the line A-A' in Fig. 17(a);

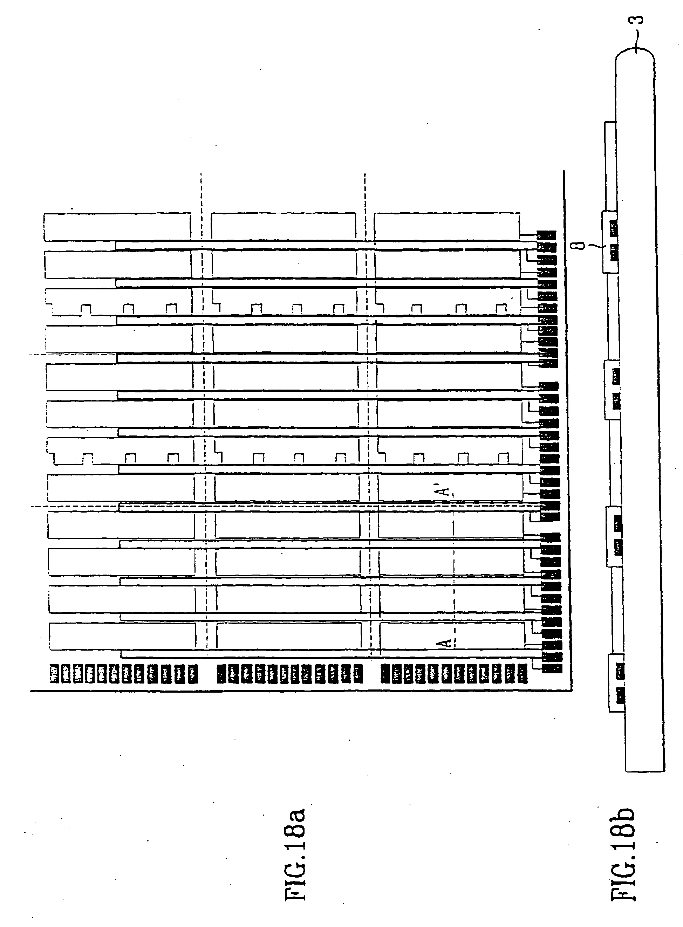

Fig. 18(a) is a plan view showing the process of covering first bus electrodes with an insulating layer, and Fig. 18(b) illustrates a cross-sectional view taken along the line A-A' in Fig. 18(a);

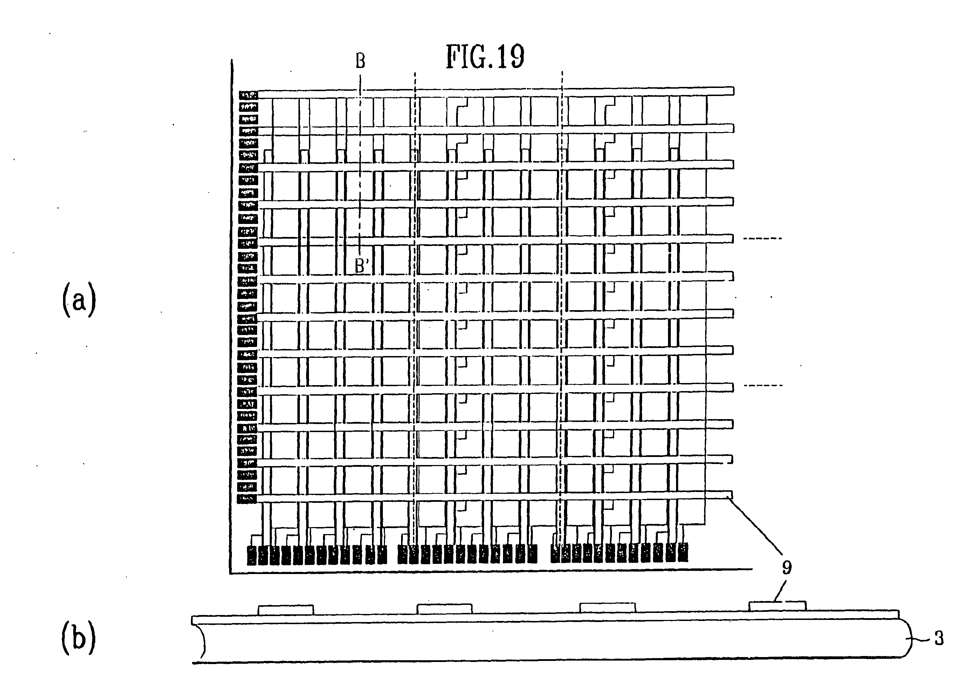

Fig. 19 is a schematic view illustrating the process of forming an insulating buffer layer for second bus electrodes;

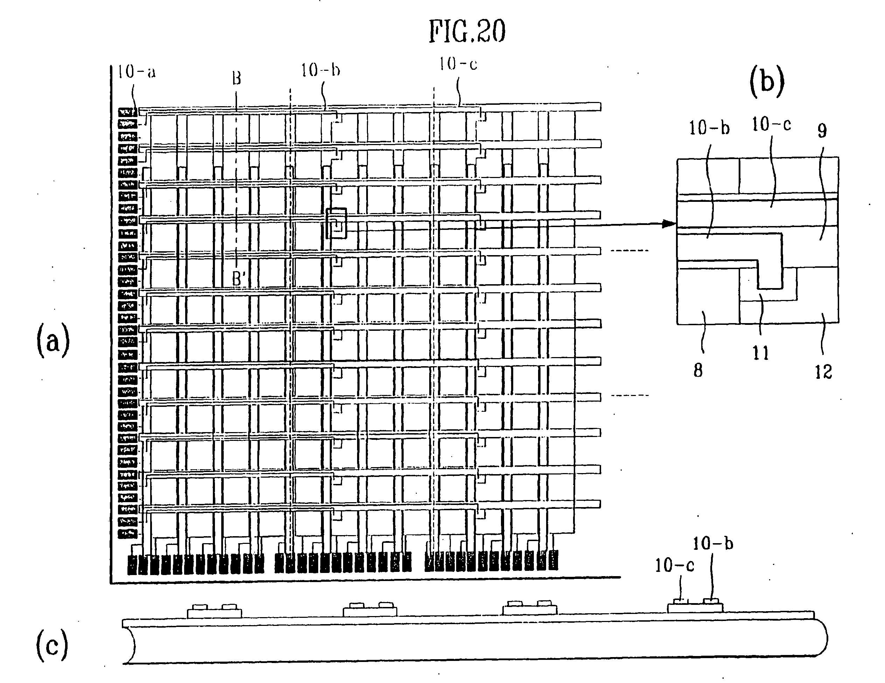

Fig. 20(a) is a schematic view illustrating the process of forming second bus electrodes;
Fig. 20(b) is a blow-up, and Fig. 20(c) illustrates a cross-sectional view taken along the line B-B' in Fig. 20(a);

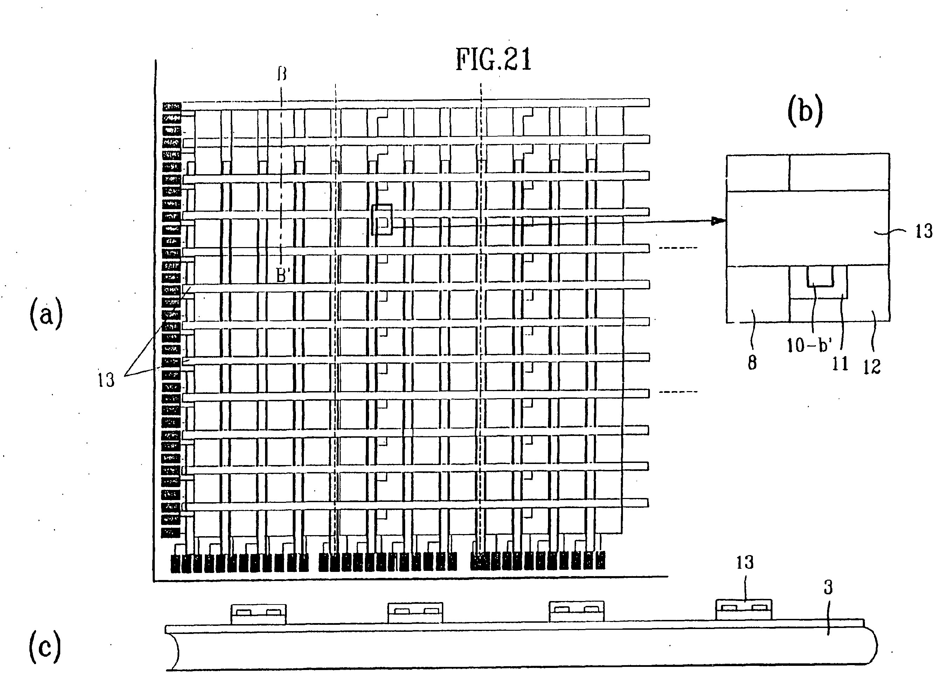

Fig. 21 is a plan view illustrating the process of forming an insulating layer for second bus electrodes;

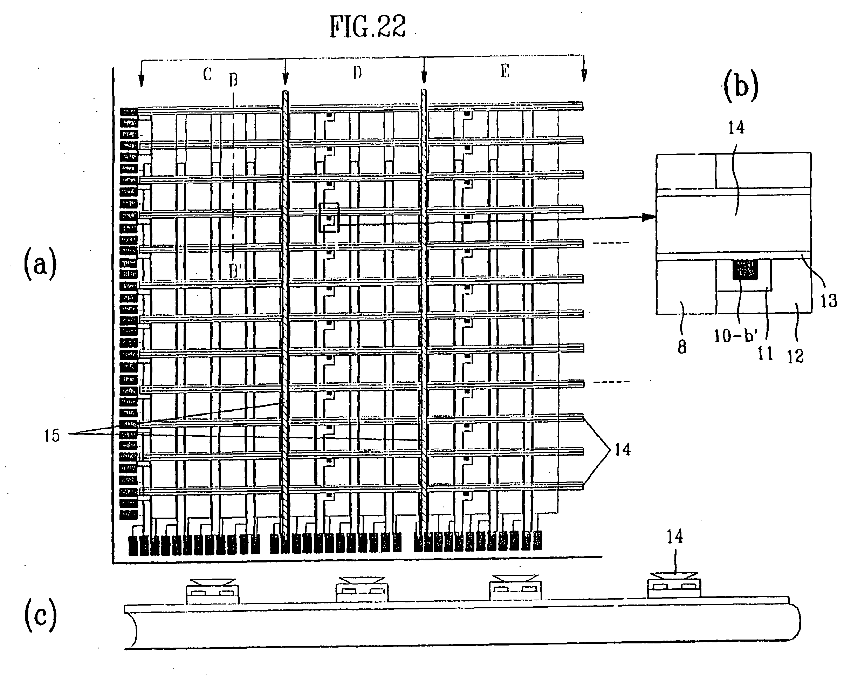

Fig. 22 illustrates the process of forming electrically insulating ramparts for separating second electrodes laterally and also those for isolating the groups of second electrodes in C, D and E regions;

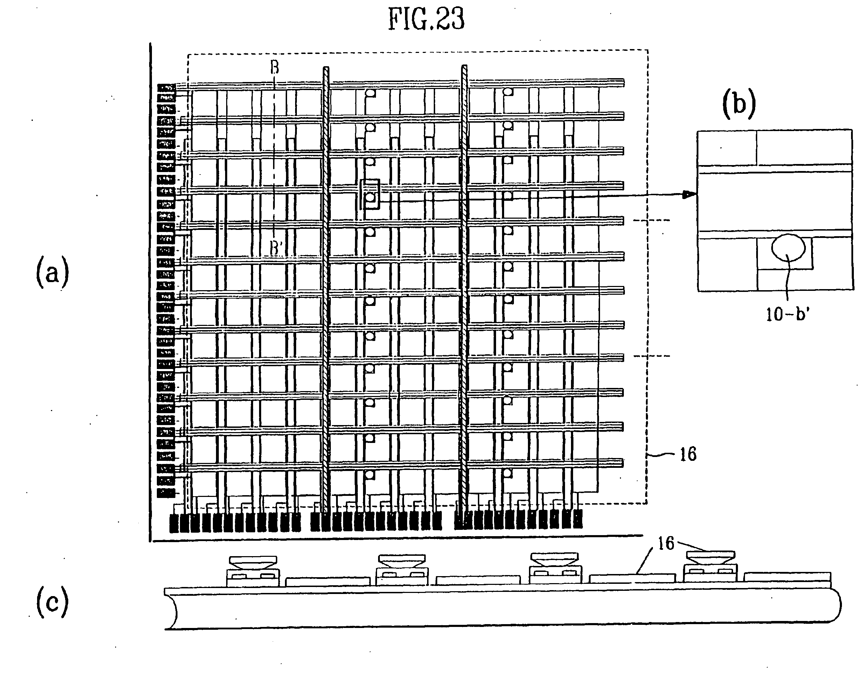

Fig. 23 illustrates the process of laminating organic function layers and exposing a part of second bus electrode 10-b' by etching out organic function layers on top of said bus electrode 10-b';

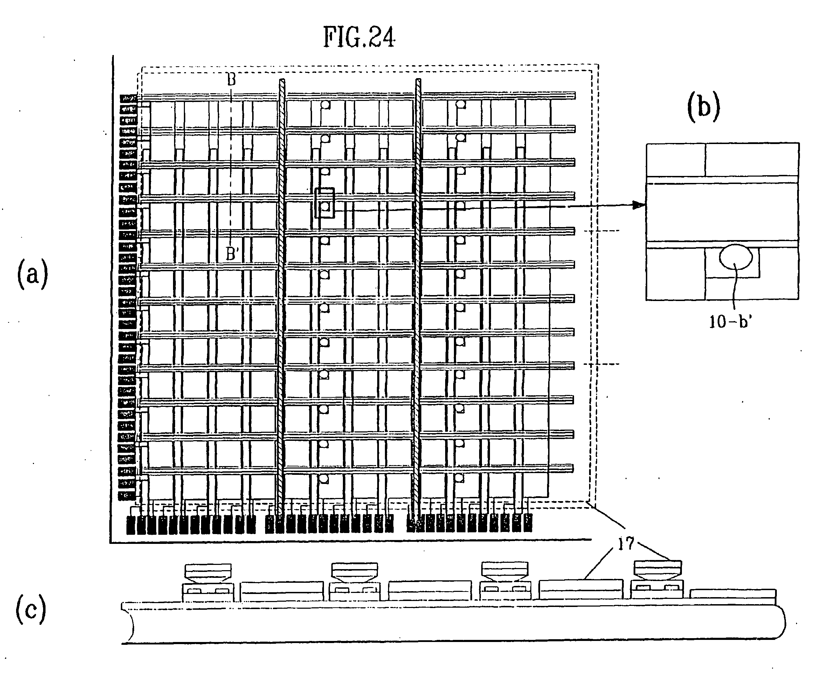

Fig. 24 illustrates the process of forming second electrodes;

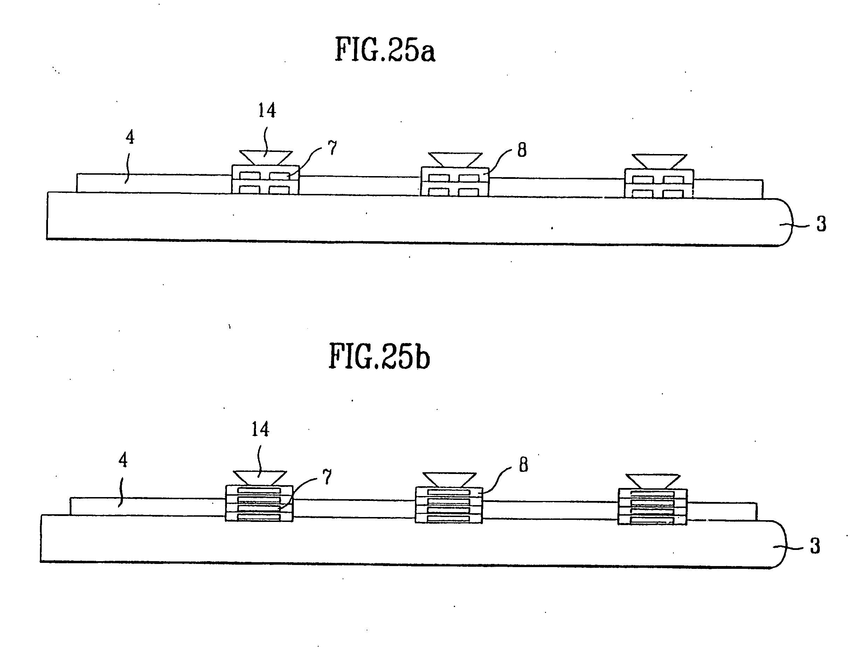

Fig. 25 is a sectional view illustrating the prototypical methods of forming a multilayer of second bus electrodes: (a) two lanes of bus electrode per layer and (b) a single lane per layer; and

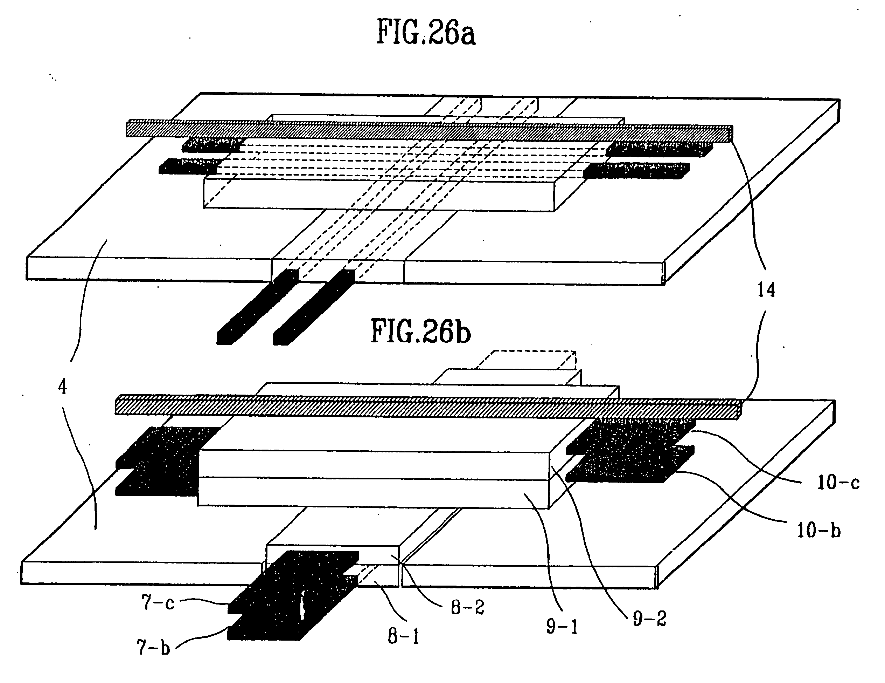

Fig. 26 is a perspective view describing the intersections of first and second bus electrodes: (a) two lanes of bus electrode per layer and (b) a single lane per layer.

### DETAILED DESCRIPTION OF THE PREFERRED EMBODIMENT

Reference will now be made in detail to the preferred embodiments of the present invention, examples of which are illustrated in the accompanying drawings.

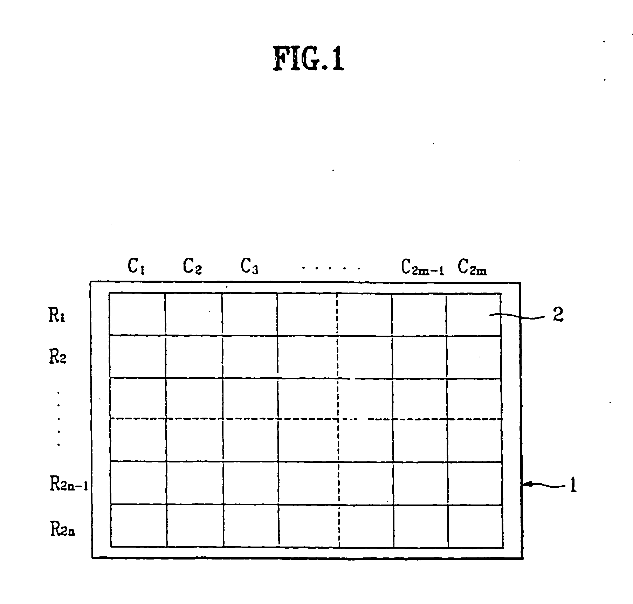

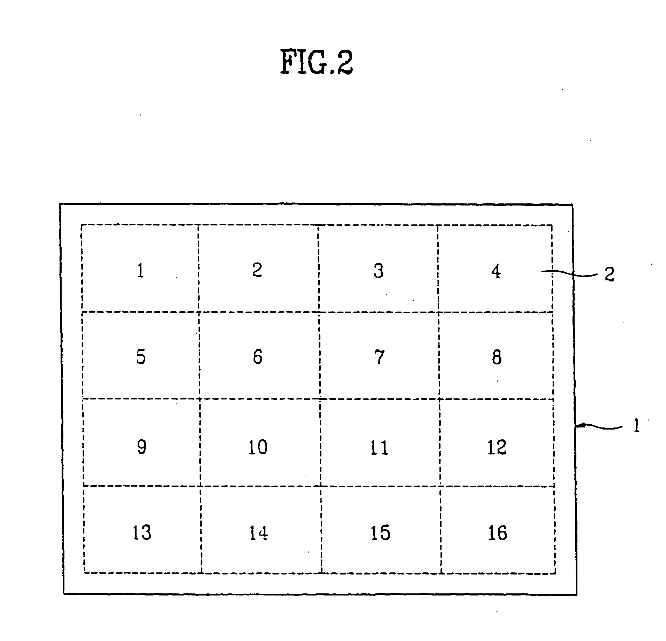

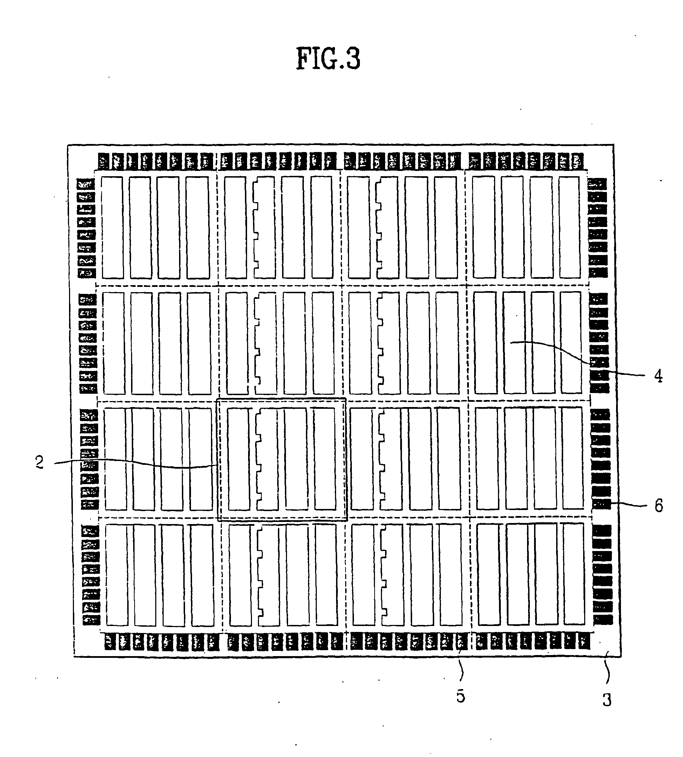

Fig. 1 schematically illustrates a plan view of an organic EL display panel in accordance with a preferred embodiment of the present invention. The organic EL display panel 1 has a large viewing area which is divided into sub-panels 2 of (2m x 2n), i.e. columns of 2m and rows of 2n. wherein m and n are integers greater than 2. Each sub-panel will be electrically driven separately to obviate the problems associated with a passive addressing of a large panel. Fig. 2 shows specifically a display panel having (4 x 4) sub-panels. The panel 1 has an active viewing area which is constituted of sixteen sub-panels 2. A series of fabrication steps devised in the present invention have been illustrated in Figs. 3 ~ 14 for an exemplary display panel having (4 x 4) sub-panels.

In the first processing step (Fig. 3), a layer of transparent conductor(s), typically indium tin oxide (ITO), is deposited on a transparent, insulating substrate 3 and said deposited layer is patterned into a plurality of stripes 4 by photolithography. Said first electrode is apparently different from an anode used in a typical matrix addressing in that each first electrode is divided into 4 stripes. Each stripe of an electrode is electrically isolated from others, which can be utilized to drive each sub-panel 2 of the display panel separately. Fig. 3 also shows a plurality of contact pads 5 & 6 for first and second electrodes, respectively, formed on the transparent substrate. Said contact pads may be formed simultaneously during the formation of first electrodes.

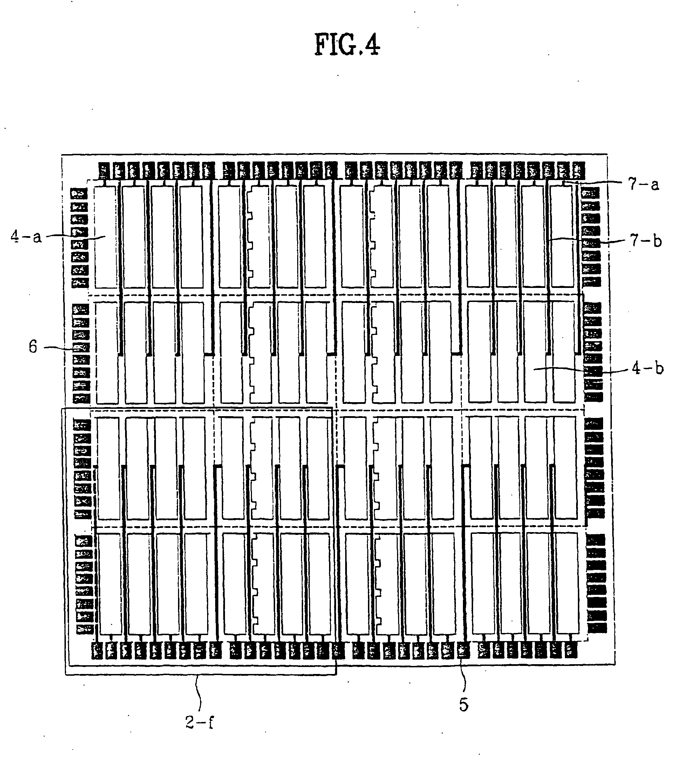

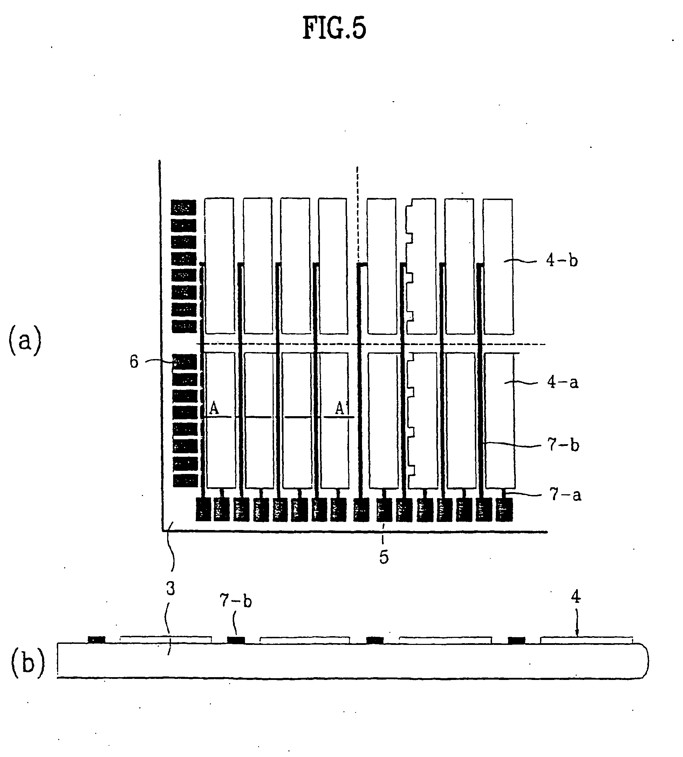

Next, electrical connections between stripes of first electrodes and corresponding contact pads are made through first bus electrodes. The short connections 7-a between outer stripes 4-a and corresponding contact pads 5 are also shown in Fig. 4, but the connections may be rather simply made during the previous step by patterning ITO in such a shape that the two are simply connected. The long connections between inner stripes 4-b and corresponding contact pads are made through first bus electrodes 7-b which are formed preferably of a highly conductive metal such as aluminum or its alloys. There are several different ways to form said first bus electrodes 7-b, and a preferred method is to form the bus electrode only on the selective position using a lift-off process. The film growth may be performed using any of vapor deposition, e-beam evaporation. RF sputtering, chemical vapor deposition (CVD), spin coating, dipping, Dr. blade method, electro- and electroless platings, and screen printing method, among other things. Fig. 5(a) is a close-up view of four sub-panels designated as 2-f in Fig. 4, and Fig. 5(b) illustrates a cross-sectional view taken along the line A-A' in Fig. 5(a).

IR potential drops along a long side of each rectangular-shaped stripe of first electrodes can be significantly reduced by increasing the contact area between each of first bus electrodes and a corresponding stripe of first electrodes, which thereby makes a contribution towards a uniform emission of a sub-panel. In a sense, said first bus electrode serves as an auxiliary electrode for a stripe of first electrode because the electrical resistance of ITO, typically used for a first electrode, is much larger than that of a metal used for a bus electrode. A preferred way is to form each bus electrode along a long side of corresponding rectangular-shaped stripe, as shown in Fig. 5-1, making the two in electrical contact over the entire length of a long side of said stripe or over a substantial fraction of the whole length of said long side. Said contacts can be either continuous or evenly distributed lengthwise along the long side of said stripe.

In the next step, a layer of electrically insulating material(s) is formed on top of said first bus electrodes 7-b (see Fig. 6). Said layer 8 is required to be mechanically and chemically stable, and may be made of organic or inorganic insulating material(s). Preferred materials are inorganic compounds such as silicon oxide and silicon nitride, and the film growth may be performed using any of vapor deposition, e-beam evaporation, RF sputtering, chemical vapor deposition (CVD), spin coating, dipping, Dr. blade method, electro- and electroless platings, and screen printing method.

Fig. 7(a) is a schematic view illustrating the process of forming an insulating buffer layer on top of which second bus electrodes are to be formed orthogonal to first bus electrodes in the following step. The role of said buffer layer 9 is to electrically isolate second bus electrodes from first electrodes. The materials and film growth methods used to form said buffer layer are basically the same as those for the insulating layer 8 in Fig. 6. Said buffer layer may be formed together with the insulating layer 8 in the previous step (see Fig. 7-1).

In the next step, second bus electrodes are formed to be orthogonal to first bus electrodes, as shown in Fig. 8. The role of said bus electrodes is to electrically connect contact pads 6 and second electrodes which are to be formed in the next process. The short connections 10-a may be omitted, depending on the structural design employed. The long connections 10-b are formed mostly on top of the insulating layer 9, and, as shown in Fig. 8(b), a part of said bus electrode (10-b') is formed on an open area 11 which is not covered with the first electrode layer 4 (ITO) unlike the area 12. Second bus electrodes can be formed using the same materials and film growth methods as for first bus electrodes.

Next, an insulating layer is formed on top of said second bus electrodes as in Fig. 9. Depending on the structural design adopted, said insulating layer 13 may be omitted. The materials and fabrication methods of said insulating layer are basically the same as those described earlier.

It should be noted in passing that second bus electrodes may be formed before first bus electrodes.

Depending on the mode of display and pixelation scheme adopted, next processing steps may vary substantially. As an example, if one chooses to separate adjacent pixels using electrically insulating ramparts as suggested in U.S. Patent No. 5701055, it may be necessary to form said ramparts on top of the insulating layer for either first or second bus electrodes, whichever formed later. For the fabrication of a monochrome display, a series of organic function materials are to be simply laminated. But the use of additional shadow mask(s) may be required for the construction of a multi or full color display: (1) putting a shadow mask onto top surfaces of the ramparts, the shadow mask having a plurality of openings each exposing one of either first or second electrodes, whichever suitable, between said ramparts, and aligning the openings to said electrodes respectively; (2) depositing first organic EL media through said openings onto said electrodes between said ramparts respectively, thereby forming first (R) organic function layers; (3) after realigning the shadow mask, repeating the process (2) to form second (G) and third (B) organic function layers; and (4) forming at least one second electrode on said ramparts and said organic function layers.

Fig. 10 illustrates the process of forming electrically insulating ramparts for pixelation as described in the above. Said ramparts 14 are formed on top of the insulating layer 13 which serves as a buffer layer here. An additional rampart 15 is required to electrically isolate second electrodes in A region from those in B region as illustrated in Fig. 11.

Next, organic function layers 16 are laminated as seen in Fig. 12. An exemplary green-emitting device may have organic function layers of: (1) a hole injecting buffer layer of copper phthalocyanine (CuPc) typically 10nm ~ 20nm thick, (2) a hole transporting layer of N,N'-diphenyl-N,N'-bis(3-methylphenyl)-(1,1'-biphenyl)-4,4'-diamine (TPD) typically 30nm - 50nm thick, and (3) an emitting layer of tris(8-hydroxy-quinolate)aluminum (Alq₃) 40nm ~ 60nm thick which is often doped with a fraction of an emitting dye such as coumarin 6 or quinacridone. One of the preferred methods to fabricate a full color display panel is to laminate each of red, green and blue emitting materials onto the corresponding pixels step by step using a plurality of ramparts and shadow mask(s), as described earlier.

Fig. 13 illustrates the process of exposing a part of second bus electrode 10-b' by etching out organic function layers deposited right on top of said bus electrode 10-b' for the purpose of making an electrical contact between said bus electrode and the second electrode layer which is to be deposited in the following step (Fig. 14). The etching can be accomplished preferably using a dry etching process such as reactive ion etching or laser etching. Figures show, for clarity, only one window for electrical contact per each of second bus electrodes, but the number of said contact windows or connection pads may be increased to, for example, one per each pixel, if necessary. For most applications, one contact window per each bus electrode is sufficient because the material for a second electrode (Al, or Al:Li) generally has much lower resistivity compared to that for a first electrode (ITO).

After the formation of second electrodes, the formation of protective layer(s) and an encapsulation process are followed to complete the panel fabrication.

The exemplary fabrication processes described for (4 x 4) sub-panels are applicable to the fabrication of an even larger panel of (6 x 6) sub-panels as shown in Fig. 15. Due to the symmetry involved, description with respect to only (3 x 3) sub-panels (fig. 16) should be sufficient to elucidate the fabrication steps of (6 x 6) sub-panels. The illustrations of Figs 17 - 24 concern the processing steps for said panel with (3 x 3) sub-panels, which are basically the same as those for (4 x 4) described already. But there are several differences as follows. As seen in Fig. 17, it is necessary to form one more bus electrodes per each first electrode compared to (4 x 4). Here two lanes of bus electrodes are shown to be laid down side by side, but it is also possible to form a multilayer structure by stacking a lane per each layer, as shown in Fig. 25(b). Fig. 20 shows again the presence of one more bus electrodes per each second electrode compared to (4 x 4), i.e. 10-a, 10-b and 10-c.

In general, the fabrication scheme described above can be extended to the fabrication of a display panel with (2m x 2n) or (m x n) sub-panels. If so, as shown in Fig. 25, bus electrodes need to be formed in a multilayer structure. These multilayer bus electrodes may be formed either thin or thick film processing technologies. For reference, Fig. 26 is a perspective view describing the intersections of first and second bus electrodes.

Each of the sub-panels fabricated as described above can be driven using a driving circuitry which is separate, but not completely independent from the remaining circuitry. Separate driving here means that each sub-panel has separate scan and data lines which should be properly synchronized with the remaining circuitry.

The organic EL devices have the following advantages.

Effective driving of a large organic EL display panel has been made possible by forming a plurality of stripes for each of first electrodes and also for each of second electrodes. These stripes are electrically isolated from each other, which enables each group of pixels defined by a set of orthogonal stripes to be driven separately from the remaining groups of pixels. Efficient fabrication methods devised to construct said display panel are cost effective and suitable for mass production.

## Claims

1. A passive addressing organic electroluminescent display panel (1) comprising:
a plurality of first electrodes (4), and a plurality of second electrodes (17), orthogonal to said first electrodes, forming a matrix of columns and rows; and
a plurality of light emitting portions (16) laminated between the.first and second electrodes,
**characterised in that**:
the matrix of electrodes is divided into m x n separately electrically drivable sub-panels (2), where m and n are integers greater than 2,
each first electrode (4) is made up of m conductive stripes electrically isolated from each other, arranged such that each conductive stripe drives light emitting portions of a different one of the sub-panels along the length direction of the first electrode;
each second electrode (17) is made up of n conductive stripes electrically isolated from each other, arranged such that each conductive stripe drives light emitting portions of a different one of the sub-panels along the length direction of the second electrode; and
the display panel further comprises separate driving circuitry for each sub-panel (2), a substrate (3), said plurality of first electrodes (4) formed on said substrate, a plurality of first bus electrodes (7-b) between adjacent first electrodes, and each stripe of each of said plurality of first electrodes being electrically connected to a respective first bus electrode (7-b),
wherein a plurality of second bus electrodes (10-b) are formed in rows orthogonal to and over said first bus electrodes and insulated from said substrate (3) for exposing at least portions of the first electrodes respectively; and
the light emitting portion is formed of at least one of first, second and third organic function layers (16) formed on said exposed portions of said first electrodes (4), each of said organic function layers including at least one organic EL medium layer, said plurality of second electrodes (17) formed on said organic function layers (16) and each stripe of each of said plurality of second electrodes being electrically connected to a respective second bus electrode (10-b),
wherein the end of the second bus electrode is coupled to a corresponding second electrode stripe via an opening formed in one of the first, second and third organic function layers.

2. The organic EL display panel of claim 1, wherein each of said first and second bus electrodes (7-b, 10-b) comprises a portion of a multilayer vertically stacked structure with an electrically insulating layer in between, each of said multilayer vertically stacked structure comprises one of said plurality of first and second bus electrodes (7-b, 10-b) arranged side by side with an electrically insulating gap in between.

3. The organic EL display panel of claim 1, wherein each conductive stripe of said first electrodes and a corresponding first bus electrode are formed to remain in electrical contact at at least one location.

4. The organic EL display panel of claim 1, wherein said first and second bus electrodes (7-b, 10-b) are made of at least one conductive material and said substrate is made of a transparent material.

5. The organic EL display panel of claim 4, wherein said electrically conductive material consists of at least one of metals, alloys and conducting polymers.

6. The organic EL display panel of claim 5, wherein said metal is one of aluminium, copper, nickel, chromium, silver and gold.

7. A method of making an passive addressing organic electroluminescent display panel comprising the steps of:
forming a plurality of first electrodes (4) and a plurality of second electrodes (17) in a matrix of columns and rows on a substrate with a plurality of light emitting portions (16) laminated therebetween,
**characterised in that**:
the matrix of electrodes is divided into m x n separately electrically drivable sub-panels (2), where m and n are integers greater than 2;
each first electrode (4) is made up of m first conductive stripes electrically isolated from each other and arranged such that each conductive stripe drives light emitting portions of a different one of the sub-panels along the length direction of the first electrode;
each second electrode (17) is made up of n second conductive stripes electrically isolated from each other and arranged such that each conductive stripe drives light emitting portions of a different one of the sub-panels along the length direction of the second electrode; and
further comprising providing separate driving circuitry for each sub-panel (2),
wherein the step of forming a plurality of first electrodes and a plurality of second electrodes in a matrix with a plurality of light emitting portions laminated therebetween, comprises the steps of:
after forming the first electrodes (4), forming a plurality of first signal bus electrodes (7-b) between adjacent first electrodes in a column direction and each of the first electrodes being coupled to a corresponding stripe of the first electrodes;
forming a plurality of second signal bus electrodes (10-b) in a row direction and insulated from the substrate for exposing at least portions of the first electrodes respectively;
forming at least one of first, second and third organic function layers on the exposed portions of the first electrodes (4), each of said first, second and third organic function layers including at least one organic electroluminescent medium; and
forming the plurality of second electrodes (17) on at least one of first, second and third organic function layers and each stripe of which is coupled to a corresponding second signal bus electrode (10-b),
wherein the end of at least one second signal bus electrode is coupled to a corresponding second electrode via an opening formed in one of the first, second and third organic function layers.

8. The method of claim 7, wherein the end of the second signal bus electrode (10-b) is formed substantially perpendicular to the main portion of the second signal bus electrode.

9. The method of claim 8, wherein said first conductive stripe has a substantially rectangular shape, and a plurality of notches are formed on one side of the first conductive stripe.

10. The method of claim 9, wherein each second signal bus electrode protrudes into an area defined by a corresponding notch.

## Patentansprüche

1. Passives organisches Elektrolumineszenz-Anzeigefeld (1), welches Folgendes aufweist:
eine Vielzahl erster Elektroden (4), sowie eine Vielzahl zweiter Elektroden (17), welche orthogonal zu den ersten Elektroden angeordnet sind, wodurch eine Matrix aus Spalten und Reihen gebildet wird; und
eine Vielzahl von lichtemittierenden Abschnitten (16), welche zwischen den ersten und zweiten Elektroden angeordnet bzw. laminiert sind;
**dadurch gekennzeichnet, dass**:
die Matrix aus Elektroden in m x n separat elektrisch ansteuerbare Teilfelder (2) unterteilt ist, wobei m und n ganze Zahlen größer als 2 sind;
wobei jede erste Elektrode (4) aus m leitfähigen Streifen besteht, welche voneinander elektrisch isoliert sind und derart angeordnet sind, dass jeder leitfähige Streifen lichtemittierende Abschnitte eines unterschiedlichen Teilfelds entlang der Längsrichtung der ersten Elektrode ansteuert;
wobei jede zweite Elektrode (17) aus n leitfähigen Streifen besteht, welche voneinander elektrisch isoliert sind und derart angeordnet sind, dass jeder leitfähige Streifen lichtemittierende Abschnitte eines jeweils unterschiedlichen der Teilfelder entlang der Längsrichtung der zweiten Elektrode ansteuert;
das Anzeigefeld des Weiteren eine separate
Ansteuerungsschaltkreisanordnung für jedes Teilfeld (2), ein Substrat (3), die Vielzahl auf dem Substrat ausgebildeter erster Elektroden (4) sowie eine Vielzahl erster Bus-Elektroden (7-b) zwischen benachbarten ersten Elektroden aufweist, und wobei jeder Streifen einer jeden aus der Vielzahl erster Elektroden mit einer jeweiligen ersten Bus-Elektrode (7-b) elektrisch verbunden ist,
wobei eine Vielzahl zweiter Bus-Elektroden (10-b) in Reihen ausgebildet sind, welche orthogonal zu und überhalb der ersten Bus-Elektroden angeordnet sind und von dem Substrat (3) isoliert sind, um jeweils zumindest Abschnitte der ersten Elektroden freizulegen bzw. zu exponieren; und
der lichtemittierende Abschnitt aus mindestens entweder ersten, zweiten oder dritten organischen Funktionsschichten (16) gebildet ist, welche auf den exponierten Abschnitten der ersten Elektroden (4) ausgebildet sind, wobei jede der organischen Funktionsschichten mindestens eine organische Elektrolumineszenz(EL)-Schicht einschließt, wobei die auf den organischen Funktionsschichten (16) ausgebildete Vielzahl von zweiten Elektroden (17) und jeder Streifen jeder aus der Vielzahl von zweiten Elektroden mit einer jeweiligen zweiten Bus-Elektrode (10-b) elektrisch verbunden ist,
wobei das Ende der zweiten Bus-Elektrode mit einem jeweiligen zweiten Elektroden-Streifen über eine Öffnung verbunden ist, welche in einer der ersten, zweiten und dritten organischen Funktionsschichten ausgebildet ist.

2. Organisches EL-Anzeigefeld nach Anspruch 1, **dadurch gekennzeichnet, dass** jede der ersten und zweiten Bus-Elektroden (7-b, 10-b) einen Abschnitt eines mehrschichtigen vertikal übereinander angeordneten Gefüges mit einer dazwischenliegenden elektrischen Isolierschicht aufweist, wobei jedes mehrschichtige vertikal übereinander angeordnete Gefüge eine Elektrode aus der Vielzahl erster und zweiter Bus-Elektroden (7-b, 10-b) aufweist, welche nebeneinander mit einem dazwischenliegenden elektrisch isolierenden Spalt angeordnet sind.

3. Organisches EL-Anzeigefeld nach Anspruch 1, **dadurch gekennzeichnet, dass** jeder leitfähige Streifen der ersten Elektroden und eine entsprechende erste Bus-Elektrode derart ausgebildet sind, dass sie an mindestens einer Position in elektrischem Kontakt zueinander bleiben.

4. Organisches EL-Anzeigefeld nach Anspruch 1, **dadurch gekennzeichnet, dass** die ersten und zweiten Bus-Elektroden (7-b, 10-b) aus mindestens einem leitfähigen Werkstoff hergestellt sind, und dass das Substrat aus einem transparenten Werkstoff besteht.

5. Organisches EL-Anzeigefeld nach Anspruch 4, **dadurch gekennzeichnet, dass** der elektrisch leitfähige Werkstoff aus zumindest entweder Metallen, Legierungen sowie leitfähigen Polymeren besteht.

6. Organisches EL-Anzeigefeld nach Anspruch 5, **dadurch gekennzeichnet, dass** es sich bei dem Metall um entweder Aluminium, Kupfer, Nickel, Chrom, Silber oder Gold handelt.

7. Verfahren zur Herstellung eines passiven organischen Elektrolumineszenz-Anzeigefeldes, wobei das Verfahren die folgenden Schritte aufweist:
Ausbilden einer Vielzahl erster Elektroden (4) sowie einer Vielzahl zweiter Elektroden (17) in einer Matrix aus Spalten und Reihen auf einem Substrat, wobei eine Vielzahl lichtemittierender Abschnitte (16) dazwischen angeordnet bzw. laminiert wird;
**dadurch gekennzeichnet, dass**:
die Matrix von Elektroden in m x n separat elektrisch ansteuerbare Teilfelder (2) unterteilt wird, wobei m und n ganze Zahlen größer als 2 sind;
jede erste Elektrode (4) aus m ersten leitfähigen Streifen besteht, welche voneinander elektrisch isoliert und derart angeordnet sind, dass jeder leitfähige Streifen lichtemittierende Abschnitte unterschiedlicher Teilfelder entlang der Längsrichtung der ersten Elektrode ansteuert;
jede zweite Elektrode (17) aus n zweiten leitfähigen Streifen besteht, welche voneinander elektrisch isoliert und derart angeordnet sind, dass jeder leitfähige Streifen lichtemittierende Abschnitte unterschiedlicher Teilfelder entlang der Längsrichtung der zweiten Elektrode ansteuert; und
das Verfahren des Weiteren die Bereitstellung jeweils einer separaten Ansteuerungs-Schaltkreisanordnung für jedes Teilfeld (2) aufweist;
wobei der Schritt der Ausbildung einer Vielzahl erster Elektroden sowie einer Vielzahl zweiter Elektroden in einer Matrix mit einer Vielzahl dazwischen angeordneter lichtemittierender Abschnitte die folgenden Schritte aufweist:
nach der Ausbildung der ersten Elektroden (4), Ausbildung einer Vielzahl erster Signalbus-Elektroden (7-b) zwischen benachbarten ersten Elektroden in Spaltenrichtung und wobei jede der ersten Elektroden mit einem jeweiligen Streifen der ersten Elektroden verbunden ist;
Ausbildung einer Vielzahl zweiter Signalbus-Elektroden (10-b) in Reihenrichtung und von dem Substrat isoliert, um zumindest jeweils Abschnitte der ersten Elektroden zu exponieren;
Ausbildung mindestens entweder erster, zweiter oder dritter organischer Funktionsschichten auf den exponierten Abschnitten der ersten Elektroden (4), wobei jede der ersten, zweiten und dritten organischen Funktionsschichten mindestens einen organischen Elektrolumineszenz-Werkstoff einschließt; und
Ausbildung der Vielzahl zweiter Elektroden (17) auf mindestens einer von ersten, zweiten und dritten organischen Funktionsschichten, und wobei jeder ihrer Streifen mit einer jeweiligen zweiten Signalbus-Elektrode (10-b) verbunden ist,
wobei das Ende mindestens einer zweiten Signalbus-Elektrode mit einer entsprechenden zweiten Elektrode über eine Öffnung gekoppelt ist, welche in einer der ersten, zweiten und dritten organischen Funktionsschichten ausgebildet ist.

8. Verfahren nach Anspruch 7, **dadurch gekennzeichnet, dass** das Ende der zweiten Signalbus-Elektrode (10-b) im Wesentlichen senkrecht zu dem Hauptabschnitt der zweiten Signalbus-Elektrode ausgebildet ist.

9. Verfahren nach Anspruch 8, **dadurch gekennzeichnet, dass** der erste leitfähige Streifen eine im Wesentlichen rechteckige Form aufweist, und dass eine Vielzahl von Einschnitten auf einer Seite des ersten leitfähigen Streifens ausgebildet wird.

10. Verfahren nach Anspruch 9, **dadurch gekennzeichnet, dass** jede zweite Signalbus-Elektrode in einen Bereich hineinragt, welcher durch einen entsprechenden Einschnitt definiert bzw. begrenzt ist.

## Revendications

1. Panneau d'affichage électroluminescent organique (1) à adressage passif comprenant :
une pluralité de premières électrodes (4), et une pluralité de secondes électrodes (17), orthogonales auxdites premières électrodes, formant une matrice de colonnes et de lignes ; et
une pluralité de parties émettant de la lumière (16) stratifiées entre les premières et secondes électrodes ;
**caractérisé en ce que** :
la matrice d'électrodes est divisée en m x n sous-panneaux (2) électriquement attaquables séparément, où m et n sont des entiers supérieurs à 2 ;
chaque première électrode (4) est composée de m bandes conductrices isolées électriquement les unes des autres, agencées de sorte que chaque bande conductrice attaque des parties émettant de la lumière d'un sous-panneau différent parmi les sous-panneaux le long de la direction de longueur de la première électrode ;
chaque seconde électrode (17) est composée de n bandes conductrices isolées électriquement les unes des autres, agencées de sorte que chaque bande conductrice attaque des parties émettant de la lumière d'un sous-panneau différent parmi les sous-panneaux le long de la direction de longueur de la seconde électrode ; et
le panneau d'affichage comprend en outre un ensemble de circuits d'attaque séparé pour chaque sous-panneau (2), un substrat (3), ladite pluralité de premières électrodes (4) formées sur ledit substrat, une pluralité de premières électrodes bus (7-b) entre des premières électrodes adjacentes, et chaque bande de chacune de ladite pluralité de premières électrodes étant connectée électriquement à une première électrode bus respective (7-b) ;
où une pluralité de secondes électrodes bus (10-b) sont formées en lignes orthogonalement auxdites premières électrodes bus et sur celles-ci et isolées dudit substrat (3) pour exposer au moins des parties des premières électrodes respectivement ; et
la partie émettant de la lumière est formée d'au moins une couche parmi une première, une seconde et une troisième couches à fonction organique (16) formées sur lesdites parties exposées desdites premières électrodes (4), chacune desdites couches à fonction organique comportant au moins une couche de milieu électroluminescent organique, ladite pluralité de secondes électrodes (17) formées sur lesdites couches à fonction organique (16) et chaque bande de chacune de ladite pluralité de secondes électrodes étant connectée électriquement à une seconde électrode bus (10-b) respective ;
où l'extrémité de la seconde électrode bus est couplée à une seconde bande d'électrode correspondante par le biais d'une ouverture formée dans l'une des première, seconde et troisième couches à fonction organique.

2. Panneau d'affichage électroluminescent organique de la revendication 1, dans lequel chacune desdites premières et secondes électrodes bus (7-b, 10-b) comprend une partie d'une structure multicouches empilées à la verticale avec une couche électriquement isolante au milieu, chacune desdites structure multicouches empilées à la verticale comprend l'une de ladite pluralité de premières et secondes électrodes bus (7-b, 10-b) agencées côte-à-côte avec un jeu électriquement isolant au milieu.

3. Panneau d'affichage électroluminescent organique de la revendication 1, dans lequel chaque bande conductrice desdites premières électrodes et une première électrode bus correspondante sont formées pour rester en contact électrique au niveau d'au moins un endroit.

4. Panneau d'affichage électroluminescent organique de la revendication 1, dans lequel lesdites premières et secondes électrodes bus (7-b, 10-b) sont réalisées à partir d'au moins un matériau conducteur et ledit substrat est réalisé à partir d'un matériau transparent.

5. Panneau d'affichage électroluminescent organique de la revendication 4, dans lequel ledit matériau électriquement conducteur consiste en au moins un matériau parmi des métaux, des alliages et des polymères conducteurs.

6. Panneau d'affichage électroluminescent organique de la revendication 5, dans lequel ledit métal est l'un de l'aluminium, du cuivre, du nickel, du chrome, de l'argent et de l'or.

7. Procédé de fabrication d'un panneau d'affichage électroluminescent organique à adressage passif comprenant les étapes qui consistent à :
former une pluralité de premières électrodes (4) et une pluralité de secondes électrodes (17) en une matrice de colonnes et de lignes sur un substrat avec une pluralité de parties émettant de la lumière (16) stratifiées entre elles ;
**caractérisé en ce que** :
la matrice d'électrodes est divisée en m x n sous-panneaux (2) électriquement attaquables séparément, où m et n sont des entiers supérieurs à 2 ;
chaque première électrode (4) est composée de m premières bandes conductrices isolées électriquement les unes des autres et agencées de sorte que chaque bande conductrice attaque des parties émettant de la lumière d'un sous-panneau différent parmi les sous-panneaux le long de la direction de longueur de la première électrode ;
chaque seconde électrode (17) est composée de n secondes bandes conductrices isolées électriquement les unes des autres et agencées de sorte que chaque bande conductrice attaque des parties émettant de la lumière d'un sous-panneau différent parmi les sous-panneaux le long de la direction de longueur de la seconde électrode ; et
comprenant en outre le fait de prévoir un ensemble de circuits d'attaque séparé pour chaque sous-panneau (2) ;
dans lequel l'étape consistant à former une pluralité de premières électrodes et une pluralité de secondes électrodes en une matrice avec une pluralité de parties émettant de la lumière stratifiées entre elles, comprend les étapes qui consistent à :
après avoir formé les premières électrodes (4), former une pluralité de premières électrodes de bus de signaux (7-b) entre des premières électrodes adjacentes dans une direction de colonne et chacune des premières électrodes étant couplée à une bande correspondante des premières électrodes ;
former une pluralité de secondes électrodes de bus de signaux (10-b) dans une direction de ligne et isolées du substrat pour exposer au moins des parties des premières électrodes, respectivement ;
former au moins une couche parmi une première, une seconde et une troisième couches à fonction organique sur les parties exposées des premières électrodes (4), chacune desdites première, seconde et troisième couches à fonction organique comportant au moins un milieu électroluminescent organique ; et
former la pluralité de secondes électrodes (17) sur au moins une couche parmi une première, seconde et troisième couches à fonction organique et dont chaque bande est couplée à une seconde électrode de bus de signaux correspondante (10-b),
où l'extrémité d'au moins une seconde électrode de bus de signaux est couplée à une seconde électrode correspondante par le biais d'une ouverture formée dans l'une des première, seconde et troisième couches à fonction organique.

8. Procédé de la revendication 7, dans lequel l'extrémité de la seconde électrode de bus de signaux (10-b) est formée essentiellement perpendiculaire à la partie principale de la seconde électrode de bus de signaux.

9. Procédé de la revendication 8, dans lequel ladite première bande conductrice a une forme essentiellement rectangulaire, et une pluralité d'encoches sont formées sur un côté des premières bandes conductrices.

10. Procédé de la revendication 9, dans lequel chaque seconde électrode de bus de signaux fait saillie dans une région définie par une encoche correspondante.
